**Europäisches Patentamt**

**European Patent Office**

**Office européen des brevets**

(19)

(11) Veröffentlichungsnummer : **0 139 973**
**B1**

(12)

# EUROPÄISCHE PATENTSCHRIFT

(45) Veröffentlichungstag der Patentschrift :
09.11.88

(51) Int. Cl.⁴ : **H 01 L 23/42**

(21) Anmeldenummer : 84109900.5

(22) Anmeldetag : 20.08.84

(54) **Anordnung zur Wärmeabführung bei Schichtschaltungen.**

(30) Priorität : 25.08.83 DE 3330708

(43) Veröffentlichungstag der Anmeldung :
08.05.85 Patentblatt 85/19

(45) Bekanntmachung des Hinweises auf die Patenterteilung : 09.11.88 Patentblatt 88/45

(84) Benannte Vertragsstaaten :
**DE NL**

(56) Entgegenhaltungen :
**DE-C- 1 100 176**
**US-A- 2 994 017**
**IBM TECHNICAL DISCLOSURE BULLETIN, Band 21,**
**Nr. 1, Juni 1978, Seiten 183-184, New York, US; B.E.**
**BLAKE u.a.: "Packaging structure"**
**IBM TECHNICAL DISCLOSURE BULLETIN, Band 19,**
**Nr. 7, Dezember 1976, Seite 2652, New York, US; J.M.**
**CIANCANELLI: "Circuit module with heat transfer"**
**PATENTS ABSTRACTS OF JAPAN, Band 8, Nr. 44 (E-**
**229)[1481], 25. Februar 1984; & JP - A - 58 200 560**
**(MITSUBISHI DENKI K.K.) 22.11.1983**

(73) Patentinhaber : **Siemens Aktiengesellschaft Berlin**
**und München**
**Wittelsbacherplatz 2**
**D-8000 München 2 (DE)**

(72) Erfinder : **Drekmeier, Karl Gerd**
**Bussardstrasse 42**
**D-8025 Unterhaching (DE)**
Erfinder : **Reithmaier, Egon**
**Untertaxetweg 71**
**D-8035 Gauting (DE)**

## Beschreibung

Die Erfindung bezieht sich auf eine Anordnung gemäß dem Oberbegriff des Anspruchs 1. Eine solche Anordnung ist z. B. aus dem IBM-Technical Disclosure Bulletin, Band 21, Nr. 1, Juni 1978, Seiten 183-184, New York, US bekannt.

Auf Schichtschaltungen, auf z. B. $Al_2O_3$-Keramik, können im Bereich von Leistungstransistoren, Widerständen und ähnlichen wärmeerzeugenden Bauelementen punktuell Verlustleistungen von beispielsweise 1 bis 2 Watt anfallen. Die entstehenden Wärmenester verursachen Funktionsstörungen an den Bauelementen.

Die bisher übliche Art, zur Wärmeableitung gut wärmeleitende Metallprofile ganz oder teilweise mit der Schichtschaltungsrückseite zu verbinden und gegebenenfalls mit wärmeleitenden, federnden Kontaktsystemen an Chassis-Teile (Frontplatte, Kühlrippen u. dgl.) zu kontaktieren, birgt eine Bruchgefahr für das Substrat durch die nötige Kontaktkraft und durch unterschiedliche Wärmeausdehnung von Substrat und Metallprofil in sich und erfordert zudem einen großen Aufwand durch enge Einbautoleranzen und lageabhängige Kühlkontaktmaßnahmen. Außerdem kann ein starres Einbauprinzip unzulässig hohe mechanische Spannungen am Substrat bzw. an den Anschlüssen zur Leiterplatte verursachen.

Der Erfindung liegt die Aufgabe zugrunde, unter Vermeidung der vorstehend genannten Nachteile eine Anordnung einfachen Aufbaus zur Abführung der Wärme von Schichtschaltungen zu schaffen.

Diese Aufgabe wird durch die im kennzeichnenden Teil des Anspruchs 1 definierten Merkmale gelöst.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen

Fig. 1 bis 8 verschiedene Ausführungsformen der Verbindungselemente und deren Befestigung,

Fig. 9 u. 10 zwei Ausführungsformen zweier in einem Gehäuse montierter Verbindungselemente und

Fig. 11 in einem Diagramm Kurvenscharen, die die Übertemperatur in Abhängigkeit der Länge und des Querschnitts des Verbindungselementes angeben.

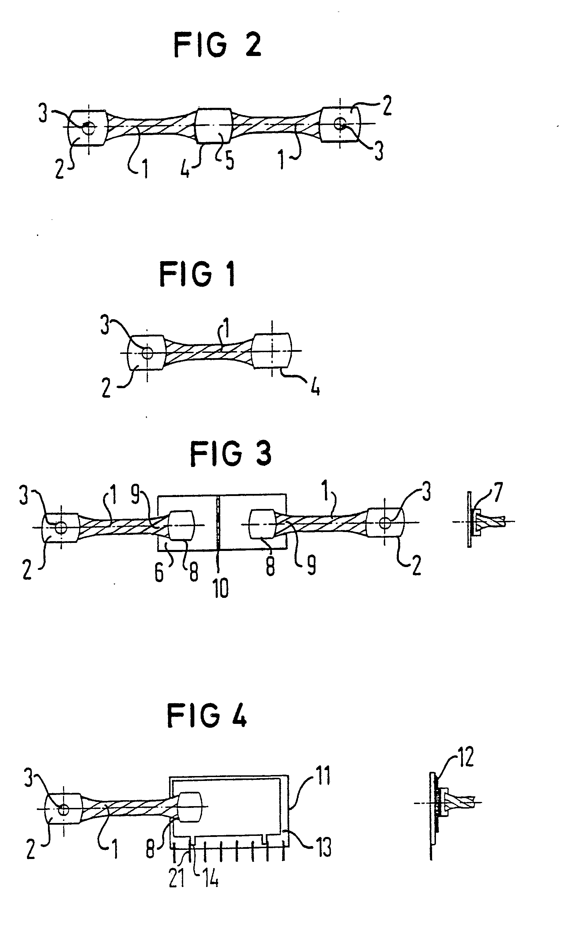

Fig. 1 zeigt die einfachste Ausführungsform eines Verbindungselementes. Das Verbindungselement besteht aus einer hochflexiblen Litze 1 aus gut wärmeleitendem Material, z. B. Kupfer, die an ihren Enden formschlüssig mit jeweils einem planen Kontaktstück 2, 4 verbunden ist, von denen das für die Befestigung am Gehäuse vorgesehene Kontaktstück 2 mit einem Befestigungsloch 3 für eine Schraube oder Niete versehen ist.

Fig. 2 zeigt ein Verbindungselement symmetrischen Aufbaus, das aus zwei hochflexiblen Litzen 1 besteht, die ein gemeinsames mittleres Kontaktstück 4 zur Verbindung mit der Schichtschaltung aufweisen und an ihrem zweiten Ende mit jeweils einem planen Kontaktstück 2 mit Befestigungslöchern 3 formschlüssig verbunden sind. Diese sind für die Verbindung mit dem Gehäuse vorgesehen. Das mittlere Kontaktstück 4 hat gegenüber der Substratfläche eine um den Faktor 5 bis 10 kleinere Kontaktfläche 5, so daß bei unterschiedlicher Wärmeausdehnung die mechanischen Spannungen am Substrat klein gehalten werden.

Fig. 3 zeigt eine Ausführungsform mit zwei Verbindungselementen entsprechend Fig. 1, bei der zusätzlich ein Wärmeleitblech 6 vorgesehen ist, das im montierten Zustand des Verbindungselementes zwischen der Substratrückseite der Schichtschaltung und den Kontaktstücken 8 des Verbindungselementes angeordnet ist. Die Verbindung der Kontaktstücke 8 der Verbindungselemente mit dem Wärmeleitblech 6 erfolgt durch Lötstellen 7 so, daß eine Versteifung in dem den Kontaktstücken 8 benachbarten Litzenbereich 9 auszuschließen ist. Das Wärmeleitblech dient der Verbesserung der Wärmeleitfähigkeit des Substrates, z. B. bei weiteren Wärmenestern und besteht aus einem flexiblen, gut wärmeleitenden Blech, beispielsweise aus Kupfer, das die Schichtschaltung mechanisch wenig belastet. Querschnitt und Materialfestigkeit des Wärmeleitblechs sind so gewählt, daß die Wärmeleitfähigkeit der Schichtschaltung 11 (vgl. Fig. 4) um ca. den Faktor 5 vergrößert wird, und daß im Verbund mit der Schichtschaltung keine schädigenden Spannungen für die Klebeverbindung 12, durch die das Wärmeleitblech mit dem Substrat verbunden ist, und das Substrat 13 selbst entstehen. Das Wärmeleitblech kann zusätzlich als elektrische Abschirmung fungieren mit entsprechenden Lötstiften 14 zur Verbindung mit Masseanschlüssen 21 der Schichtschaltung.

Der ganzflächige, möglichst dünne Klebefilm der Klebeverbindung 12 besteht aus flexibilisiertem Epoxy und ist für eine Temperatur von maximal 200 °C ausgelegt. Bei rückseitig metallisierten Substraten kann der Kühlanschluß auch z. B. mit gestuftem Lot ausgelötet werden.

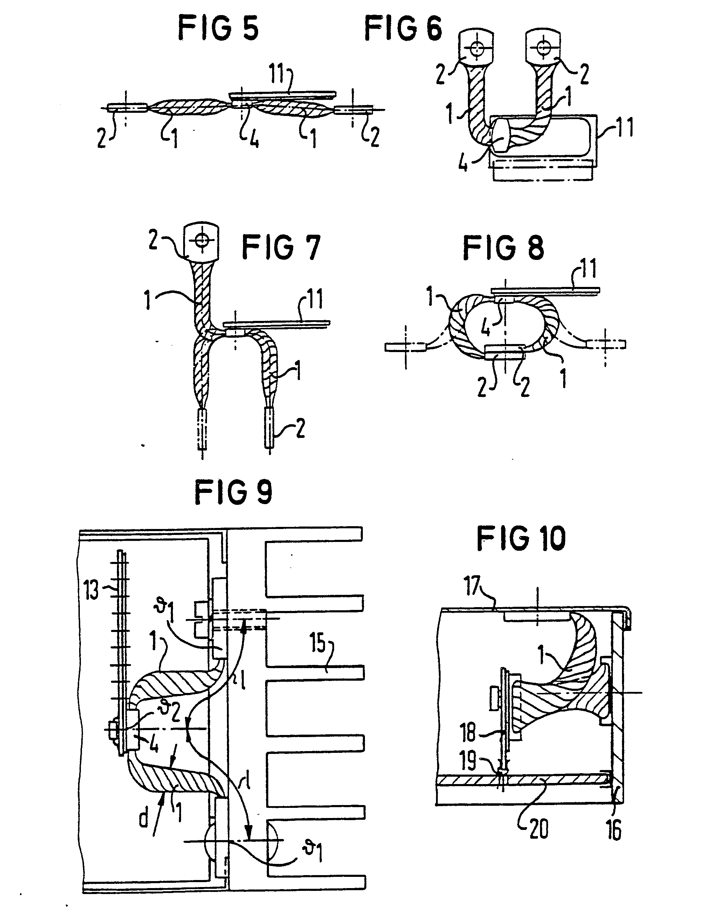

Die Figuren 5 bis 8 zeigen verschiedene Ausformungen der Verbindungselemente gemäß Fig. 2 und deren Befestigung an der Schichtschaltung. Die Ausformungen lassen erkennen, daß die Einbaulage für die Kühlanschlußenden sehr variabel ist, so daß dadurch eine Einbauabhängigkeit weitgehend entfällt, d. h. eine gerätespezifische Auslegung weitgehend nicht erforderlich ist. In den Figuren 7 und 8 ist zusätzlich noch in strichpunktierter Darstellung eine weitere Ausführungsform dargestellt als weitere Möglichkeit der Befestigung des Kühlanschlußendes am Gehäuse.

Die Fig. 9 und 10 zeigen die Einbaulage von Verbindungselementen in einem Gehäuse. Dabei ist bei der Ausführungsform nach Fig. 9 ein Verbindungselement gemäß Fig. 2 mit seinem mittleren Kontaktstück 4 an der Substratunterseite angeschlossen, während die beiden freien, mit Bohrungen versehenen Kontaktstücke des Verbindungselementes durch Schrauben oder Nieten mit einem Kühlprofil 15 des Gehäuses gut wärmeleitend verbunden sind.

Bei der Ausführungsform nach Fig. 10 sind entsprechende Verbindungselemente einseitig mit der Substratrückseite der in einer Leiterplatte 20 gehaltenen Schichtschaltung 18 verbunden, während das jeweils andere Ende der Verbindungselemente an der Frontplatte 16 bzw. am Deckel 17 des Gehäuses befestigt ist. Die entsprechenden Ausformungen halten die Schichtschaltung 18, die Anschlüsse 19, über die die Schichtschaltung 18 in der Leiterplatte 20 befestigt ist und die Leiterplatte 20 selbst weitgehend spannungsfrei und ermöglichen große Einbautoleranzen.

In Fig. 9 sind zusätzlich Bemessungsangaben für die Verbindungselemente (Länge 1, Querschnitt d) und Temperaturwerte an den verschiedenen Kontaktstücken ($\vartheta_2$ an dem an der Schichtschaltung angebrachten mittleren Kontaktstück, $\vartheta_1$ an den im Endbereich liegenden, mit der Kühlrippe verbundenen Kontaktstücken).

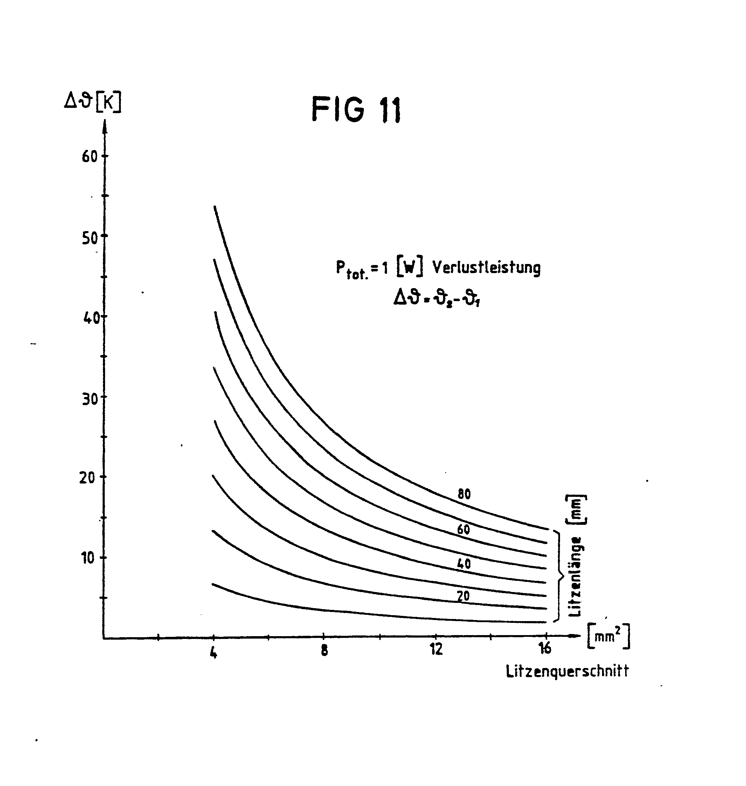

Diese Dimensionierungsangaben und Temperaturwerte dienen der Erläuterung der graphischen Darstellung nach Fig. 11, in der für eine Kurvenschar die Übertemperatur in Abhängigkeit des Litzenquerschnitts für verschiedene Litzenlängen aufgetragen ist. Die Übertemperatur $\Delta\vartheta$ ist dabei gleich der Differenz zwischen der Temperatur am mittleren, mit der Schichtschaltung verbundenen Kontaktstück und dem im Endbereich liegenden, mit der Kühlrippe verbundenen Kontaktstück des Verbindungselementes. Diese Darstellung zeigt, in welcher Weise der Wärmeleitungsgradient durch Wahl des Litzenquerschnitts und der Litzenlänge variabel ist.

## Patentansprüche

1. Anordnung zur Abführung der durch Verlustleistung bedingten Wärme von Schichtschaltungen an ein die Schichtschaltungen aufnehmendes metallisches Gehäuse mittels eines flexiblen und wärmeleitenden litzenartigen Verbindungselementes, dessen eines Ende mit der Schichtschaltung verbunden ist und dessen anderes Ende an einem wärmeableitenden Teil des Gehäuses befestigt ist, dadurch gekennzeichnet, daß beide Enden des Verbindungselementes mit einem massiven, gut wärmeleitenden Anschlußkontakt mit einer gegenüber der Substratfläche der Schichtschaltung um den Faktor 5 bis 10 kleineren Kontaktfläche versehen sind, daß der mit der Schichtschaltung verbundene Anschlußkontakt des Verbindungselementes unter Zwischenlage eines flexiblen, gut wärmeleitenden Bleches in unmittelbarer Nähe der Wärmequelle an der Substratrückseite angeordnet ist und daß das durch Kleben auf dem Substrat befestigte wärmeleitende Blech zugleich ein elektrisches Abschirmblech bildet mit Anschlußgeometrie zur Verbindung mit Masseanschlüssen der Schichtschaltung.

2. Anordnung nach Anspruch 1, dadurch gekennzeichnet, daß die Verbindung des Anschlußkontaktes des Verbindungselementes mit dem Gehäuse durch Schrauben, Nieten oder Klemmen in variablen Lagen erfolgt.

3. Anordnung nach Anspruch 1 oder 2, dadurch gekennzeichnet, daß die Verbindungselemente paarweise angeordnet sind.

4. Anordnung nach Anspruch 3, dadurch gekennzeichnet, daß zwei Verbindungselemente derart symmetrisch ausgebildet sind, daß sie einen gemeinsamen mittleren Anschlußkontakt aufweisen.

## Claims

1. An arrangement for discharging the heat resulting from power loss in layer circuits, to a metallic housing which accommodates the layer circuits, by means of a flexible and heat-conducting stranded connecting element one end of which is connected to the layer circuit and the other end of which is attached to a heat-discharging part of the housing, characterised in that both ends of the connecting element are provided with a massive, heat-conducting terminal contact having good thermal conductivity and also having a contact surface area which is a factor of 5 to 10 times smaller than the substrate surface area of the layer circuit, that that terminal contact of the connecting element which is connected to the layer circuit is arranged on the rear of the substrate in the direct vicinity of the heat source with an interlying flexible metal sheet of good thermal conductivity, and that the heat-conducting metal sheet which is bonded to the substrate simultaneously forms an electrical screening metal sheet shaped for connection to earth terminals of the layer circuit.

2. An arrangement as claimed in Claim 1, characterised in that the connection of the terminal contact of the connecting element to the housing is effected by screws, rivets or clamps in variable positions.

3. An arrangement as claimed in Claim 1 or 2, characterised in that the connecting elements are arranged in pairs.

4. An arrangement as claimed in Claim 3, characterised in that two connecting elements are arranged symmetrically in such manner that they possess a common central terminal contact.

## Revendications

1. Dispositif pour évacuer de la chaleur de puissance dissipée de circuits en couche à un boîtier métallique recevant les circuits en couche, à l'aide d'un élément de liaison du genre d'une tresse thermo-conductrice, et dont une extrémité est reliée au circuit en couche alors que son autre extrémité est fixée à une partie du boîtier, capable d'évacuer la chaleur, caractérisé par le fait que les deux extrémités de l'élément de liaison sont pourvues de contacts de liaison de masse et bon conducteurs de la chaleur ayant une surface de contact inférieure d'un facteur 5 à 10 par rapport à la surface substrat du circuit en couche, que le contact de liaison de l'élément de liaison avec le circuit en couche est disposé, avec interposition d'une tôle flexible et bonne conductrice de la chaleur, dans le voisinage immédiat de la source de chaleur, du côté postérieur du substrat, et que la tôle thermo-conductrice fixée par collage sur le substrat, forme en même temps une tôle-écran électrique avec une géométrie de raccordement pour la liaison avec des raccordements de masse du circuit en couche.

2. Dispositif selon la revendication 1, caractérisé par le fait que la liaison de contact de liaison de l'élément de liaison avec le boîtier a lieu par vis, rivets, ou bornes, dans des positions diverses.

3. Dispositif selon la revendication 1 ou 2, caractérisé par le fait que les éléments de liaison sont disposés par paires.

4. Dispositif selon la revendication 3, caractérisé par le fait que deux éléments de liaison sont conformés symétriquement de manière à comporter un contact de liaison médian commun.

# FIG 2

# FIG 1

# FIG 3

# FIG 4

0 139 973

FIG 5  FIG 6

FIG 7  FIG 8

FIG 9

FIG 10

FIG 11